# DEMANDE DE BREVET EUROPEEN

(11) **EP 1 798 772 A2**
(43) Date de publication de la demande: **20.06.2007**
(21) Numéro de dépôt: 06126270.5
(22) Date de dépôt: 15.12.2006
(51) Int. Cl.: H01L 29/74

(54) **Thyristor optimisé pour une commande HF sinusoïdale**

(30) Priorité: 16.12.2005 FR 0553914
(71) Demandeur: ST MICROELECTRONICS S.A., 92120 Montrouge (FR)
(72) Inventeur: Mauriac, Christophe, 37250, VEIGNE (FR); Menard, Samuel, 37000, TOURS (FR)
(74) Mandataire: de Beaumont, Michel

(57) **Abrégé**

L'invention concerne un thyristor vertical adapté à une commande HF, comprenant une région de cathode (4) dans un caisson de base (3) de type P, une couche faiblement dopée de type P (11) à côté du caisson de base, une région faiblement dopée de type N (13) dans ladite couche faiblement dopée de type P, un contact Schottky (MS) sur la région faiblement dopée de type N relié à une borne de commande (C), et une connexion entre la région faiblement dopée de type N (13) et le caisson de base de type P (3).

## Description

### Domaine de l'invention

La présente invention concerne la réalisation d'un thyristor optimisé pour une commande HF sinusoïdale.

### Exposé de l'art antérieur

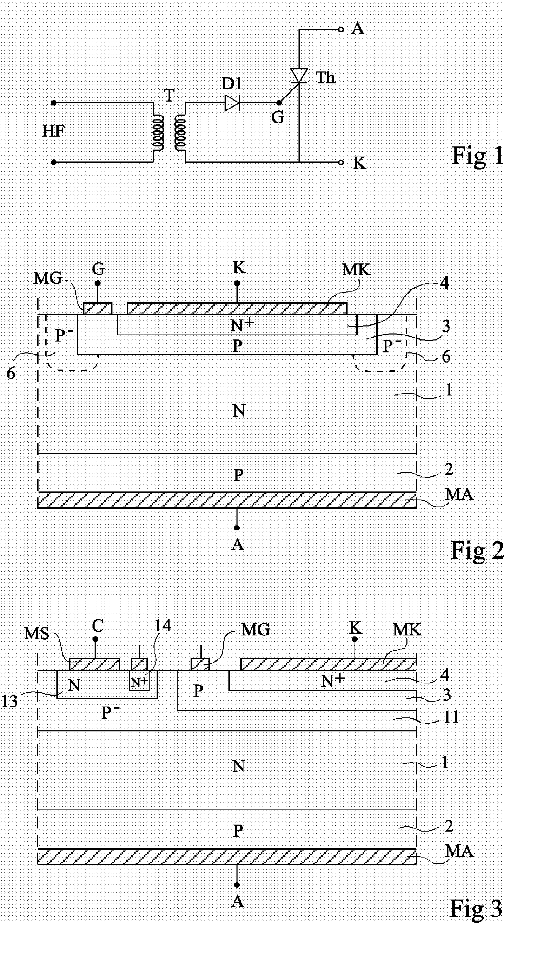

La demanderesse a déjà proposé dans le brevet des Etats-Unis d'Amérique N° 6 862 196 (B4882) une structure de commande de thyristor telle qu'illustrée en figure 1 comprenant une source de tension HF connectée par l'intermédiaire d'un transformateur T au circuit gâchette-cathode d'un thyristor Th, une diode D1 étant interposée dans ce circuit gâchette-cathode. Le thyristor Th a une borne de gâchette G, une borne d'anode A et une borne de cathode K.

Il est exposé dans le brevet US ci-dessus que, si la fréquence HF est suffisamment élevée, on peut utiliser un transformateur T miniaturisé formé sur un substrat de verre. Dans ce brevet, on donne des exemples de fréquences de fonctionnement de l'ordre de 40 MHz ou plus. Divers avantages de ce mode de commande sont mentionnés : miniaturisation du transformateur, assemblage simplifié du transformateur et du thyristor, amélioration de l'isolement, commande de thyristors tête bêche...

La présente invention propose d'augmenter encore la fréquence du signal de commande jusqu'à des valeurs de l'ordre de la centaine de MHz ou plus pour miniaturiser davantage le transformateur T.

La présente invention propose plus particulièrement une structure intégrée de diode Schottky et de thyristor pour permettre un fonctionnement à de telles très hautes fréquences.

### Résumé de l'invention

Pour atteindre ces objets, la présente invention prévoit un thyristor vertical adapté à une commande HF, comprenant une région de cathode dans un caisson de base de type P, une couche faiblement dopée de type P à côté du caisson de base, une région faiblement dopée de type N dans ladite couche faiblement dopée de type P, un contact Schottky sur la région faiblement dopée de type N relié à une borne de commande, et une connexion entre la région faiblement dopée de type N et le caisson de base de type P.

Selon un mode de réalisation de la présente invention, la couche faiblement dopée de type P s'étend également tout autour du caisson de base et sous la périphérie de celui-ci.

Selon un mode de réalisation de la présente invention, le thyristor est formé à partir d'un substrat faiblement dopé de type N, dans lequel le niveau de dopage du substrat est de l'ordre de 10¹⁴ at./cm³, le niveau de dopage de la couche faiblement dopé de type P est de l'ordre de 10¹⁵ at./cm³, et le niveau de dopage de la région faiblement dopée de type N est de l'ordre de 10¹⁶ at./cm³.

Selon un mode de réalisation de la présente invention, la connexion entre la région faiblement dopée de type N et le caisson de base de type P est réalisée par l'intermédiaire d'une région plus fortement dopée de type N formée dans la région faiblement dopée de type N.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente un circuit de commande HF de thyristor tel que décrit dans le brevet US 6 862 196 ;
la figure 2 est une vue en coupe schématique d'une structure de thyristor classique ; et
la figure 3 est une vue en coupe d'une structure intégrant un thyristor et une diode Schottky de commande selon la présente invention.

Par souci de clarté, comme cela est habituel dans la représentation des composants semiconducteurs, les éléments des diverses vues en coupe ne sont pas tracés à l'échelle.

### Description détaillée

La présente invention prévoit tout d'abord de remplacer la diode D1 de la figure 1 par une diode Schottky pour permettre de fonctionner dans des domaines de fréquences très élevées (100 MHz ou plus). D'autre part, elle propose une structure intégrant de façon monolithique un thyristor et une diode Schottky.

La figure 2 est une vue en coupe représentant schématiquement la partie centrale d'une structure classique de thyristor. Cette figure est simplifiée. Notamment on n'a pas représenté les structures périphériques destinées à assurer une tenue en tension satisfaisante.

Le thyristor de la figure 2 est formé à partir d'un substrat semiconducteur 1, couramment du silicium, faiblement dopé de type N comprenant du côté de sa face arrière une couche d'anode 2 de type P revêtue d'une métallisation de face arrière MA connectée à une borne d'anode A. Du côté de sa face avant, un caisson 3 de type P est formé dans le substrat 1 et contient une région de cathode 4 fortement dopée de type N. Une métallisation MK est formée sur la région de cathode 4 et est solidaire d'une borne de cathode K. Une métallisation de gâchette MG est formée sur une partie de la couche 3 et est solidaire d'une borne de gâchette G.

Comme cela est connu de l'homme du métier, cette structure est susceptible de nombreuses modifications et variantes pour optimiser les propriétés du thyristor, selon que l'on souhaite favoriser la tenue en tension, la tenue en dV/dT, la sensibilité... Par exemple, pour augmenter la tension de claquage d'un thyristor, il est connu d'entourer le caisson 3 d'une région 6 (représentée en pointillés en figure 2) plus faiblement dopée de type P (P⁻) que le caisson 3 et plus profonde que celui-ci.

De façon générale, le niveau de dopage du substrat 1 de type N est de l'ordre de 10¹⁴ at./cm³, le niveau de dopage des régions 2 et 3 de type P, généralement formées simultanément, est de l'ordre de 10¹⁸ at./cm³, et le niveau de dopage de la région 4 de type N⁺ est de l'ordre de 10²⁰ à 10²¹ at./cm³. Pour des régions obtenues par diffusion de dopants, ces niveaux de dopage donnés en atomes/cm³ correspondent à des niveaux de dopage au voisinage des surfaces apparentes des régions considérées, ces niveaux de dopage étant sensiblement constants jusqu'à une profondeur correspondant sensiblement aux deux tiers de la profondeur de la zone considérée.

Comme cela a été indiqué précédemment, la présente invention vise à réaliser sous forme monolithique une diode Schottky connectée comme la diode D1 en série avec la borne de gâchette d'un thyristor. Pour que cette diode Schottky soit polarisée dans la bonne direction, il convient que la métallisation Schottky soit formée sur une zone faiblement dopée de type N. Ainsi, une solution qui apparaît à l'homme de l'art consiste à isoler une portion du substrat 1 faiblement dopée de type N, et à former un contact Schottky sur cette portion de substrat. Néanmoins, une telle solution implique de délimiter une partie du substrat par des murs d'isolement et cela entraîne une consommation importante de surface de silicium et donc une augmentation du coût.

La présente invention propose une solution beaucoup plus économe en surface de silicium telle qu'illustrée schématiquement dans la vue en coupe de la figure 3. Dans la partie droite de cette figure, on retrouve les éléments de thyristor déjà décrits en relation avec la figure 2 à savoir le substrat 1 faiblement dopé de type N, la couche d'anode 2 dopée de type P, la métallisation de face arrière MA, la borne d'anode A, la couche 3 de type P du côté de la face avant, la couche de cathode 4 fortement dopée de type N, la métallisation de cathode MK, la borne de cathode K, et la métallisation de gâchette MG. En plus, selon la présente invention, il est prévu de former du côté de la face avant du thyristor une couche 11 faiblement dopée de type P. La couche 11 est normalement obtenue par diffusion ou par implantation-diffusion et est de préférence plus profonde que le caisson de type P 3. Elle s'étend donc sous le caisson de type P 3, ou sous la périphérie de ce caisson, et de part et d'autre de ce caisson. Un avantage qu'il y a à prévoir la couche 11 plus profonde que le caisson de type P 3 est que ceci permet d'améliorer la tenue en tension du thyristor comme cela a été indiqué ci-dessus. Ainsi, dans le cas de certains thyristors haute tension, l'utilisation d'une couche 11 faiblement dopée de type P dans le cadre de la présente invention n'augmente pas le nombre d'étapes de fabrication.

Une région 13 faiblement dopée de type N est formée dans la région 11 de type P à côté du caisson 3. Sur cette région 13 de type N est formé un contact Schottky par le dépôt d'une métallisation choisie MS connectée à une borne de commande C. Egalement, sur la région 13 de type N est pris un contact ohmique, par exemple en prévoyant une région de type N plus fortement dopée 14, reliée à la métallisation MG. La borne C correspond bien alors à l'anode d'une diode Schottky en série avec la gâchette du thyristor.

Avec cette structure, on peut obtenir une diode Schottky de caractéristiques satisfaisantes en maintenant les niveaux de dopage d'un thyristor classique, à savoir un niveau de dopage de l'ordre de 10¹⁴ at./cm³ pour le substrat 1, un niveau de dopage de l'ordre de 10¹⁸ at./cm³ pour les régions de type P 2 et 3, généralement formées simultanément, et un niveau de dopage de l'ordre de 10²⁰ à 10²¹ at./cm³ pour la région de type N⁺ 4. On pourra alors réaliser la couche 11 faiblement dopée de type P avec un niveau de dopage de l'ordre de 10¹⁵ at./cm³ puis la région 13 de type N avec un dopage de l'ordre de 10¹⁶ at./cm³. Cet ordre de grandeur (5.10¹⁵ à 5.10¹⁶ at./cm³) du niveau de dopage de la région 13 est tout à fait compatible avec la réalisation d'une diode Schottky de bonne qualité dont le contact Schottky est constitué de titane, platine/nickel, nickel ou analogue.

L'existence d'une portion 11 de type P à côté et éventuellement en dessous du caisson 3 de type P ne modifie pas les caractéristiques du thyristor et le maintien du caisson de type P 3 avec le même dopage et les mêmes caractéristiques que dans le thyristor de l'art antérieur de la figure 2 permet que l'on conserve les caractéristiques souhaitées pour un thyristor réalisé selon des technologies éprouvées.

Diverses variantes de la présente invention sont accessibles à l'homme de l'art. Bien que dans un mode de réalisation préféré on préfère former la couche 11 par diffusion ou implantation/diffusion, on pourra dans des technologies, où des dépôts épitaxiaux sont prévus, prévoir que cette couche 11 résulte d'une épitaxie. Ceci permet d'optimiser encore le niveau de dopage recherché de la région N de type 13 constituant la cathode d'une diode Schottky.

## Revendications

1. Thyristor vertical adapté à une commande HF, comprenant une région de cathode (4) dans un caisson de base (3) de type P, **caractérisé en ce qu'**il comprend :
une couche de type P (11) à côté du caisson de base, faiblement dopée par rapport au caisson de base,
une région de type N (13) dans ladite couche faiblement dopée de type P, faiblement dopée par rapport à la région de cathode,
un contact Schottky (MS) sur la région faiblement dopée de type N relié à une borne de commande (C), et
une connexion entre la région faiblement dopée de type N (13) et le caisson de base de type P (3).

2. Thyristor selon la revendication 1, dans lequel la couche faiblement dopée de type P (11) s'étend également tout autour du caisson de base (3) et sous la périphérie de celui-ci.

3. Thyristor selon la revendication 1, formé à partir d'un substrat (1) faiblement dopé de type N, dans lequel le niveau de dopage du substrat (1) est de l'ordre de 10¹⁴ at./cm³, le niveau de dopage de la couche (11) faiblement dopé de type P est de l'ordre de 10¹⁵ at./cm³, et le niveau de dopage de la région (13) faiblement dopée de type N est de l'ordre de 10¹⁶ at./cm³.

4. Thyristor selon la revendication 1, dans lequel la connexion entre la région (13) faiblement dopée de type N et le caisson de base de type P est réalisée par l'intermédiaire d'une région plus fortement dopée de type N (14) formée dans la région faiblement dopée de type N (13).
